# FASCICULE DE BREVET EUROPEEN

(11) **EP 3 219 749 B1**
(45) Date de publication et mention de la délivrance du brevet: **23.06.2021**
(21) Numéro de dépôt: 17290033.4
(22) Date de dépôt: 03.03.2017
(51) Int. Cl.: H01L 23/00, C08K 7/28, C08L 63/00, H01L 23/29, C08L 61/04

(54) **MATÉRIAU DE LEURRAGE ULTRASONORE, EN PARTICULIER POUR SYSTÈME D'ARME**
MATERIAL ZUR ULTRASCHALLMASKIERUNG, INSBESONDERE FÜR WAFFENSYSTEM
ULTRASONIC DECOY MATERIAL, IN PARTICULAR FOR WEAPON SYSTEM

(30) Priorité: 15.03.2016 FR 1600425
(43) Date de publication de la demande: 20.09.2017
(73) Titulaire: MBDA France, 92350 Le Plessis-Robinson (FR)
(72) Inventeur: DUPRE, René, 92350 Le Plessis Robinson (FR)
(74) Mandataire: Gevers & Orès

(56) Documents cités:
- FR-A1- 2 872 610
- US-A- 5 030 796
- US-A1- 2002 006 986
- US-A1- 2011 227 603
- US-B1- 6 287 985
- US-B1- 6 374 675

## Description

La présente invention concerne un matériau de leurrage ultrasonore destiné à recouvrir au moins un composant électronique d'un dispositif électronique, en particulier d'un système d'arme tel qu'un missile par exemple.

Dans le cadre de la présente invention :
- un dispositif électronique comprend au moins un composant électronique et est destiné à mettre en œuvre au moins une fonction électronique. Ce dispositif électronique peut, notamment, correspondre à une carte électronique qui, de façon usuelle, comporte, en particulier, un circuit imprimé pourvu d'une pluralité de composants électroniques ;
- un matériau de leurrage ultrasonore est un matériau apte à leurrer (c'est-à-dire à induire en erreur) un examen (ou analyse) réalisé par ultrasons et plus généralement à rendre inopérant un tel examen de type ultrasonore (ou ultrasonique), comme précisé ci-dessous.

Ce matériau de leurrage a, notamment, pour objet de se prémunir contre d'éventuelles opérations de rétro conception pouvant être perpétrées sur une fonction électronique mise en oeuvre sur un dispositif électronique, notamment une carte électronique, tel que précité.

On entend par « rétro conception », toute intrusion ou toute tentative d'intrusion consistant pour une personne à accéder ou à tenter d'accéder à des informations stockées dans un dispositif électronique notamment en vue de les copier, et plus particulièrement, dans le cadre de la présente invention, une intrusion mise en œuvre à l'aide d'une détection ultrasonore.

On sait que, pour protéger les dispositifs électroniques contre une rétro conception et empêcher des concurrents, ou des ennemis dans le cas d'un équipement militaire, d'accéder à la technologie stockée dans l'équipement, ces dispositifs sont souvent entourées complètement par une résine d'enrobage.

Généralement, cette résine qui est de couleur, empêche une visualisation directe des éléments recouverts par ladite résine.

Si un individu veut quand même essayer de visualiser les éléments ainsi protégés, il essaiera en général d'utiliser des techniques d'examen non invasif, notamment, de type ultrasonore.

Un tel examen est généralement réalisé à l'aide d'un microscope acoustique et a pour objectif de réaliser une cartographie d'une fonction électronique dans le but d'en tirer des informations dimensionnantes (positionnement, taille, forme, nombre,...).

La présente invention concerne un système d'arme comprenant un dispositif électronique et un matériau d'enrobage qui, tout en étant fabriqué facilement et à coût réduit, permet de rendre inopérant un examen non invasif de type ultrasonore.

Plus précisément, le matériau d'enrobage de la présente invention concerne un matériau dit de leurrage ultrasonore, qui comprend au moins une résine.

Selon l'invention, ledit matériau de leurrage ultrasonore est remarquable en ce qu'il comprend, de plus, une pluralité de billes creuses noyées dans ladite résine.

Ainsi, grâce à l'invention, on crée un matériau dont la résine comprend une pluralité de zones de délamination (absence de matière) au niveau de la partie interne creuse (vide de matériau) des billes creuses noyées dans la résine. Ces zones de délamination créent une multitude d'interfaces qui rendent inopérant un examen ultrasonore, à l'aide d'un microscope acoustique.

Ainsi, on est en mesure de rendre inexploitable par un système de microscopie acoustique une zone (partielle ou totale) d'un composant électronique ou même d'une fonction électronique, en l'encapsulant au moyen dudit matériau de leurrage ultrasonore.

Dans un mode de réalisation préféré, lesdites billes creuses sont sensiblement uniformément réparties dans ladite résine.

En outre, de façon avantageuse, certaines desdites billes creuses sont réalisées dans au moins l'une des matières suivantes :
- du verre ;
- de la résine phénolique.

Selon l'invention, les billes creuses comprennent un diamètre global compris entre 20 et 100 µm. En outre, dans un mode de réalisation particulier, le matériau de leurrage ultrasonore comprend des billes creuses présentant des diamètres différents.

Par ailleurs, dans un mode de réalisation particulier, ladite résine est réalisée dans au moins l'une des matières suivantes : époxy, polyuréthane, phénolique.

Le dispositif électronique, en particulier une carte électronique, comprend au moins un composant électronique.

Ledit dispositif électronique comprend un enrobage entourant au moins ledit composant électronique, et ledit enrobage est réalisé, au moins en partie, dans le matériau de leurrage ultrasonore spécifié ci-dessus, qui permet de rendre inopérante une détection ultrasonore.

Ainsi, une personne qui prévoit de réaliser une rétro conception sur le dispositif électronique du système d'arme, par l'intermédiaire d'une détection ultrasonore, n'est pas en mesure de faire un examen du ou des composants électroniques protégés par la résine d'enrobage.

Les figures annexées feront bien comprendre comment l'invention peut être réalisée. Sur ces figures, des références identiques désignent des éléments semblables.
La figure 1 est une vue schématique d'un matériau de leurrage ultrasonore.
La figure 2 est une vue schématique, en coupe, d'une carte électronique, dont certains composants électroniques sont enrobés d'un matériau de leurrage ultrasonore.
Les figures 3A et 3B sont des vues schématiques de face d'un dispositif de détection ultrasonore, respectivement, selon deux modes de réalisation différents.
La figure 4 est une image obtenue par un examen ultrasonore sur un matériau de leurrage ultrasonore.

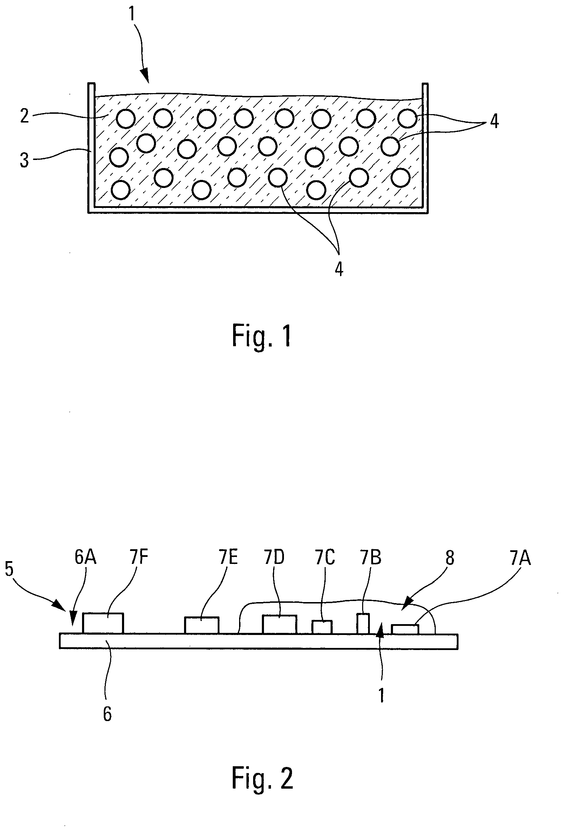

La présente invention concerne un système d'arme comprenant un dispositif électronique et un matériau d'enrobage destiné à rendre inopérant un examen de type ultrasonore. Plus précisément, elle concerne un matériau 1 dit de leurrage ultrasonore, qui comprend au moins une résine 2, comme représenté sur la figure 1, sur laquelle la résine 2 est introduite dans un récipient 3 représenté schématiquement.

Selon l'invention, ledit matériau 1 de leurrage ultrasonore comprend, de plus, une pluralité de billes creuses 4 noyées dans ladite résine 2, comme visible sur la figure 1.

On entend par « billes creuses », des objets creux de toutes formes possibles, et de préférence sphériques, qui sont dépourvues de matière à l'intérieur d'une enveloppe.

Dans un mode de réalisation préféré, lesdites billes creuses 4 sont (sensiblement) uniformément réparties dans ladite résine 2.

Ces billes creuses 4 peuvent être réalisées en différents matériaux comme du verre, de la résine phénolique,... Le but de ces billes creuses 4 est de générer une multitude de zones sans matière dans le matériau 1.

Selon l'invention, les billes creuses 4 comprennent un diamètre global compris entre 20 et 100 µm. On entend par « diamètre global » d'une bille creuse, le diamètre d'une sphère dans laquelle peut être inscrit ladite bille creuse.

À titre d'illustration, la concentration de billes creuses 4 dans le matériau 1 peut varier en fonction notamment du diamètre des billes, de la masse des billes par rapport à celle de la résine,...

Par ailleurs, dans le cadre de la présente invention, ladite résine 2 peut être réalisée dans toutes les familles de résines liquides. De préférence, ladite résine 2 est réalisée dans un au moins l'une des matières suivantes : époxy, polyuréthane, phénolique.

On obtient ainsi un matériau 1 de masse réduite, qui, tout en étant fabriqué facilement et à coût réduit comme précisé ci-dessous, permet de rendre inopérant un examen non invasif de type ultrasonore.

La taille des billes creuses 4, ainsi que leur répartition et leur concentration dans la résine 2, sont variables et adaptées de préférence à l'application envisagée du matériau 1 de leurrage ultrasonore.

Le matériau 1 peut notamment comporter des billes de diamètres différents.

Une application préférée dudit matériau 1 concerne l'enrobage de composant(s) électronique(s) d'un dispositif électronique 5 d'un système d'arme.

Sur la figure 2, on a représenté schématiquement, à titre d'exemple, un dispositif électronique 5, en l'occurrence une carte électronique, permettant d'illustrer cette application préférée de l'invention.

Ce dispositif électronique 5 comporte, de façon usuelle :
- un circuit imprimé 6 (circuit imprimé de connexions) ; et
- des composants électroniques 7A à 7F usuels, qui sont agencés sur ledit circuit imprimé 2 sur une face supérieure 6A du circuit imprimé 2. Au moins certains desdits composants électroniques 7A à 7F sont rendus intelligents par l'adjonction d'au moins un programme et/ou d'informations sensibles.

Ce dispositif électronique 5 est destiné à être monté de façon usuelle sur un système d'arme (non représenté), notamment de type missile. Il peut contenir, en particulier, des informations permettant de commander ou contrôler le fonctionnement du système d'arme considéré ou de moyens particuliers de ce dernier.

Une zone (ou partie) du dispositif électronique 5 pourvue des composants électroniques 7A à 7D a été encapsulée par du matériau 1 de leurrage ultrasonore, tel que décrit ci-dessus, formant un enrobage 8.

L'occultation réalisée par le matériau 1 a pour but donc d'interdire la réalisation d'un examen, à l'aide d'un microscope acoustique.

L'occultation réalisée par le matériau 1 a pour but donc d'interdire la réalisation d'un examen, à l'aide d'un microscope acoustique.

Par ailleurs, en raison de la présence des billes creuses 4, la masse du matériau 1 est réduite par rapport à celle de la résine 2 seule.

En outre, le matériau 1 peut être fabriqué :
- facilement, en mélangeant les billes creuses 4 dans une résine 2 liquide, avant de la chauffer pour la rendre solide et obtenir le matériau 1. Pour ce faire, le matériau utilisé pour les billes creuses doit présenter une résistance suffisante pour ne pas se déformer, ou tout au plus dans des limites acceptables, sous l'effet de la dilatation de l'air se trouvant à l'intérieur des billes creuses, lorsque la résine est chauffée ; et
- à coût réduit, en utilisant des billes du commerce à faible coût.

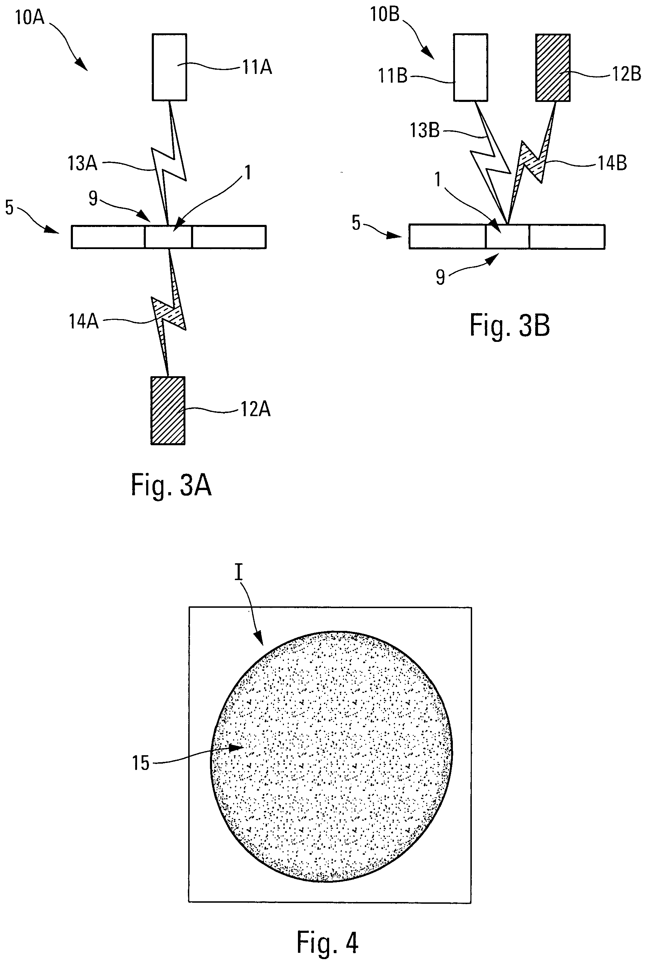

Une rétro conception à l'aide d'une détection ultrasonore utilise généralement un système d'analyse acoustique (ou microscope acoustique) 10A, 10B qui est un moyen d'analyse apte à mettre en évidence des problèmes de délaminations entre matériaux. Il permet également de détecter la présence de matériaux différents dans un assemblage, en particulier dans un dispositif électronique 5 tel qu'illustré schématiquement sur les figures 3A et 3B.

Pour ce faire, le dispositif électronique 5 à analyser est immergé dans un liquide de couplage (non représenté) qui permet le couplage ultrasonore entre une sonde d'émission 11A, 11B, une sonde de réception 12A, 12B et une partie (ou zone) 9 du dispositif électronique 5 à analyser.

Le principe du système d'analyse acoustique 10A, 10B est de générer des ultrasons 13A, 13B à l'aide de la sonde d'émission 11A, 11B et d'analyser le signal correspondant 14A, 14B reçu à l'aide d'une sonde de réception 12A, 12B. Les signaux émis et reçus sont focalisés par une lentille intégrée à chaque sonde.

La réception du signal peut se faire de deux manières :
- soit par transmission, comme représenté sur la figure 3A. Dans ce cas, le système d'analyse acoustique 10A analyse le signal reçu après le passage dans la partie 9 à analyser ;
- soit par réflexion, comme représenté sur la figure 3B. Dans ce cas, le système d'analyse acoustique 10B analyse le signal renvoyé par la partie 9 à analyser.

Le signal émis par la sonde d'émission (ou source ultrasonore) 11A, 11B pénètre dans la partie 9 à analyser. Ce signal va être modifié en passant dans les différents matériaux constituant cette partie 9.

La vitesse et la phase du signal sont modifiées en fonction des matériaux. Le signal est modifié par les propriétés intrinsèques du matériau (densité, élasticité, viscosité, porosité, adhérence,...).

Le système d'analyse acoustique 10A, 10B compare les signaux émis et reçus. Cette analyse permet, après un traitement des signaux, de mettre en évidence la présence ou non de différents matériaux ou d'irrégularités intrinsèques. En effet, à chaque fois que le signal passe d'un matériau à un autre, le signal transmis est modifié. Dans le cas d'un matériau homogène, il n'existe qu'une seule interface, et le signal n'a qu'une seule vitesse de déplacement. Le résultat de l'examen est visualisé par le système en nuance de gris ou en fausse couleur. Une délamination (présence d'air entre deux matériaux) est visualisée par une couleur blanche.

La figure 4 illustre schématiquement une image I obtenue par un tel système d'analyse acoustique 10A, 10B, d'un matériau 1 de leurrage ultrasonore.

Le résultat obtenu se traduit par une image I piquetée de taches 15 (de couleur blanche) correspondant aux billes creuses 4 incorporées au sein de la résine 2, rendant ainsi non détectables les éléments constitutifs de la fonction enrésinée avec ce matériau 1.

En fonction de la taille, la concentration et la répartition des billes creuses, on obtient un matériau plus ou moins occultant, ce qui se traduit par une image plus ou moins piquetée.

Le matériau 1 de leurrage ultrasonore, tel que décrit ci-dessus, présente donc notamment les avantages suivants :
- une fabrication simple et à coût réduit ;
- une occultation à des rayons ultrasonores ; et
- une diminution de masse par rapport à une résine sans billes creuses.

## Revendications

1. Système d'arme comportant au moins un dispositif électronique, en particulier une carte électronique, comprenant au moins un composant électronique (7A à 7F) et au moins un enrobage (8) entourant au moins ledit composant électronique (7A à 7D),
**caractérisé en ce que** ledit enrobage (8) est réalisé dans un matériau (1) de leurrage ultrasonore comprenant une résine (2) et une pluralité de billes creuses (4) noyées dans ladite résine (2), lesdites billes creuses (4) comprenant un diamètre global entre 20 et 100 µm.

2. Système d'arme selon la revendication 1,
**caractérisé en ce que** ladite résine (2) est réalisée dans au moins l'une des matières suivantes : époxy, polyuréthane, phénolique.

3. Système d'arme selon l'une des revendications 1 et 2,
**caractérisé en ce qu'**au moins certaines desdites billes creuses (4) sont réalisées dans au moins l'une des matières suivantes :
- du verre ;
- de la résine phénolique.

4. Système d'arme selon l'une des revendications précédentes,
**caractérisé en ce que** les billes creuses (4) présentent une pluralité de diamètres différents.

## Patentansprüche

1. Waffensystem, umfassend mindestens eine elektronische Vorrichtung, insbesondere eine elektronische Karte, umfassend mindestens einen elektronischen Bestandteil (7A bis 7F) und mindestens eine Einkapselung (8), die mindestens den elektronischen Bestandteil (7A bis 7D) umgibt,
**dadurch gekennzeichnet, dass** die Einkapselung (8) aus einem Ultraschall-Maskierungsmaterial (1) hergestellt ist, umfassend ein Harz (2) und eine Vielzahl von in das Harz (2) eingebetteten Hohlkugeln (4), wobei die Hohlkugeln (4) einen Gesamtdurchmesser zwischen 20 und 100 µm umfassen.

2. Waffensystem nach Anspruch 1,
**dadurch gekennzeichnet, dass** das Harz (2) aus mindestens einem der folgenden Materialien hergestellt ist: Epoxid, Polyurethan, phenolisch.

3. Waffensystem nach einem der Ansprüche 1 und 2,
**dadurch gekennzeichnet, dass** mindestens einige der Hohlkugeln (4) aus mindestens einem der folgenden Materialien hergestellt sind:
- Glas;
- Phenolharz.

4. Waffensystem nach einem der vorstehenden Ansprüche,
**dadurch gekennzeichnet, dass** die Hohlkugeln (4) eine Vielzahl verschiedener Durchmesser aufweisen.

## Claims

1. Weapon system comprising at least one electronic device, in particular an electronic board, comprising at least one electronic component (7A to 7F) and at least one coating (8) surrounding at least said electronic component (7A to 7D),
**characterised in that** said coating (8) is made of an ultrasonic masking material (1) comprising one resin (2) and a plurality of hollow spheres (4) embedded in said resin (2), said hollow spheres (4) comprising an overall diameter of between 20 and 100 µm.

2. Weapon system according to claim 1,
**characterised in that** said resin (2) is made of at least one of the following materials: epoxy, polyurethane, phenolic.

3. Weapon system according to one of claims 1 and 2, **characterised in that** at least some of said hollow spheres (4) are made of at least one of the following materials:
- glass;
- phenolic resin.

4. Weapon system according to any one of the preceding claims, **characterised in that** the hollow spheres (4) have a plurality of different diameters.
